# EUROPÄISCHE PATENTANMELDUNG

(11) **EP 0 630 058 A2**
(43) Veröffentlichungstag der Anmeldung: **21.12.1994**
(21) Anmeldenummer: 94107004.7
(22) Anmeldetag: 04.05.1994
(51) Int. Cl.: H01L 37/02, G01J 5/34, H01L 21/306

(54) **Verfahren zur Herstellung einer Pyrodetektoranordnung durch elektronisches Ätzen eines Silizium Substrats**

(30) Priorität: 19.05.1993 DE 4316853
(71) Anmelder: SIEMENS AKTIENGESELLSCHAFT, D-80333 München (DE)
(72) Erfinder: Bruchhaus, Rainer, Dr., D-80997 München (DE); Lehmann, Volker, Dr., D-80689 München (DE)

(57) **Zusammenfassung**

Zur Herstellung einer Pyrodetektoranordnung werden in einer ersten Hauptfläche (22) eines Substrats (21) aus n-dotiertem, monokristallinem Silizium durch elektrochemisches Ätzen Lochstrukturen (24) erzeugt, so daß ein strukturierter Bereich (26) in dem Substrat (21) entsteht. Oberhalb des strukturierten Bereichs (26) wird auf der ersten Hauptfläche (22) mindestens ein Pyrodetektorelement (28) angeordnet.

## Beschreibung

Bei der Herstellung von integrierten Pyrodetektoranordnungen werden einzelne Pyrodetektorelemente auf einem Substrat aufgebaut. Je nach Anwendung der Pyrodetektoranordnung umfaßt diese 4 bis 256 x 256 oder noch mehr Pyrodetektorelemente.

Zur Herstellung von integrierten Pyrodetektoranordnungen werden Substrate mit niedriger Wärmeleitung und geringer Wärmekapazität benötigt, um ein empfindliches Ansprechen der Pyrodetektoranordnung sicherzustellen.

Es ist bekannt, zum Aufbau einer integrierten Pyrodetektoranordnung ein Substrat aus Silizium zu verwenden, dessen Oberfläche mit einer dünnen Membran aus Siliziumoxid und Siliziumnitrid versehen ist. Von der Rückseite her wird in das Substrat eine Vertiefung geätzt, innerhalb der die Membran aus Siliziumoxid und Siliziumnitrid von der Rückseite her freigelegt ist. Die Membran überspannt die Vertiefung. Auf der Oberfläche der Membran werden die Pyrodetektorelemente aufgebaut. Dieses Verfahren ist für großflächige Pyrodetektoranordnungen nicht geeignet, weil die Membranen nicht die notwendige mechanische Stabilität aufweisen. Ein weiteres Verfahren besteht darin, mit geringem Abstand von etwa 1 µm zur Substratoberfläche dünne Membranen an Stützpunkten aufzubauen, auf die dann Elektroden und pyroaktive Schicht aufgebracht werden. Dieses Verfahren ist unter dem Begriff Surface-Micromachining bekannt (s. z. B. D.L. Polla et al, Appl. Phys. Lett. 59, S. 3539 - 3541, (1991)).

Der Erfindung liegt das Problem zugrunde, ein Verfahren zur Herstellung einer Pyrodetektoranordnung anzugeben, mit dem es möglich ist, auch großflächige Pyrodetektoranordnungen mit ausreichender mechanischer Stabilität herzustellen.

Dieses Problem wird erfindungsgemäß gelbst durch ein Verfahren nach Anspruch 1. Weitere Ausgestaltungen der Erfindung gehen aus den Unteransprüchen hervor.

Erfindungsgemäß wird die Pyrodetektoranordnung, die mindestens ein Pyrodetektorelement umfaßt, auf einem Substrat aus Silizium realisiert, das mindestens einen durch elektrochemisches Ätzen strukturierten Bereich umfaßt. Durch elektrochemisches Ätzen in einem Elektrolyten, indem das Substrat aus n-dotiertem, monokristallinem Silizium als Anode verschaltet ist, in dem eine erste Hauptfläche des Substrats mit dem Elektrolyten in Kontakt steht und in dem eine den Ätzabtrag beeinflussende Stromdichte eingestellt wird, werden in dem Substrat Lochstrukturen erzeugt.

Da das Substrat bei der elektrochemischen Ätzung als Anode verschaltet ist, bewegen sich Minoritätsladungsträger in dem n-dotierten Silizium zu der mit dem Elektrolyten in Kontakt stehenden ersten Hauptfläche. An dieser ersten Hauptfläche bildet sich eine Raumladungszone aus. Da die elektrische Feldstarke im Bereich von Vertiefungen in der Oberfläche größer ist als außerhalb davon, bewegen sich die Minoritätsladungsträger bevorzugt zu diesen Punkten. Dadurch kommt es zu einer Strukturierung der ersten Hauptflache. Je tiefer eine anfänglich kleine Unebenheit durch die elektrochemische Ätzung wird, desto mehr Minoritätsladungsträger bewegen sich wegen der vergrößerten elektrischen Feldstärke dorthin und desto stärker ist der Ätzangriff an dieser Stelle. Dadurch entstehen Lochstrukturen, die im Substrat in der kristallographischen 〈100〉-Richtung wachsen. Es ist daher vorteilhaft, ein Substrat mit 〈100〉-Orientierung zu verwenden.

Die elektrochemische Ätzung von n-dotiertem Silizium zur Herstellung von Löchern oder Gräben ist z. B. aus EP 0 296 348 A1 bekannt, in der Gräben insbesondere für DRAM-Zellen auf diese Weise hergestellt werden. Der Einsatz der elektrochemischen Ätzung bei der Herstellung von Pyrodetektoranordnungen wird dort jedoch nicht in Betracht gezogen.

In dem erfindungsgemäßen Verfahren wird in dem Substrat, auf dem die Pyrodetektoranordnung aufgebaut wird, durch elektrochemisches Ätzen ein strukturierter Bereich hergestellt. Dieser strukturierte Bereich weist wegen der Lochstrukturen eine geringe thermische Masse und eine kleine Wärmeleitfähigkeit auf. Dennoch ist er ausreichend mechanisch stabil, so daß an der Oberfläche des strukturierten Bereichs Pyrodetektorelemente, die insbesondere jeweils aus einer unteren Elektrode, einer pyroaktiven Schicht und einer oberen Elektrode bestehen, angeordnet werden können. Mit dem erfindungsgemäßen Herstellverfahren können insbesondere Pyrodetektoranordnungen hergstellt werden, die 256 x 256, vorzugsweise 8 x 8 Pyrodetektorelemente umfassen.

Es liegt im Rahmen der Erfindung, auf der ersten Hauptfläche des Substrats ebenfalls einen Ausleseschaltkreis zum Auslesen der einzelnen Pyrodetektorelemente aufzubauen. Der Ausleseschaltkreis kann sowohl oberhalb des strukturierten Bereiches als auch außerhalb des strukturierten Bereiches angeordnet werden.

Das elektrochemische Ätzen erfolgt vorzugsweise in einem sauren, fluoridhaltigen Elektrolyten. Der Ätzangriff ist dabei abhängig von der Stromdichte in der Substratscheibe und von der Fluoridkonzentration im Elektrolyten. Durch Erhöhung der Stromdichte im Elektrolyten oder durch Verminderung der Fluoridkonzentration im Elektrolyten wird der Ätzangriff vergrößert.

Zur Einstellung der Stromdichte liegt es im Rahmen der Erfindung, das Substrat von einer zweiten Hauptfläche her, die der ersten Hauptfläche gegenüberliegt, zu beleuchten.

Es liegt im Rahmen der Erfindung, vor der elektrochemischen Ätzung, die erste Hauptfläche mit einer Oberflächentopologie zu versehen. Auf diese Weise werden in der ersten Hauptfläche gezielt Vertiefungen hergestellt, an denen der Ätzangriff beim elektrochemischen Ätzen beginnt. Dadurch wird die Anordnung der Lochstrukturen vorgegeben.

Die Oberflächentopologie wird z. B. durch Erzeugung einer Fotolackmaske und anschließende alkalische Ätzung hergestellt.

Um die thermische Leitung zwischen dem strukturierten Bereich und dem übrigen Teil des Substrats weiter herabzusetzen, liegt es im Rahmen der Erfindung, vor dem elektrochemischen Ätzen in die zweite, der ersten gegenüberliegende Hauptfläche des Substrats eine Vertiefung zu ätzen. Die Vertiefung ist unterhalb des strukturierten Bereichs angeordnet. Die Vertiefung weist parallel zur ersten Hauptfläche eine Ausdehnung auf, die mindestens so groß wie diejenige des strukturierten Bereichs ist. Auf diese Weise wird die Ausdehnung des strukturierten Bereichs senkrecht zur ersten Hauptfläche auf vorzugsweise 10 bis 100 µm eingestellt.

Gemäß einer weiteren Ausführungsform der Erfindung wird die thermische Leitung zwischen dem strukturierten Bereich und dem übrigen Substrat dadurch herabgesetzt, daß im unteren Bereich der Lochstrukturen ein Netzwerk von Hohlräumen gebildet wird, wobei der Durchmesser der Hohlräume größer ist als der Durchmesser der Lochstrukturen im oberen Bereich. Dazu werden beim elektrochemischen Ätzen bei Erreichen einer vorgegebenen Tiefe der Lochstrukturen die Prozeßparameter so verändert, daß der Querschnitt der Lochstrukturen wächst. Da, wie oben ausgeführt, der Ätzangriff nur im unteren Bereich der Lochstrukturen stattfindet. Bleibt der Querschnitt der Lochstrukturen im oberen Bereich, d. h. in der Nähe der ersten Hauptfläche, dabei unverändert. Im unteren Bereich jedoch wachsen die Lochstrukturen. Dieses Anwachsen des Querschnitts der Lochstrukturen erfolgt insbesondere durch Erhöhung der Stromdichte im Elektrolyten, was vorzugsweise durch Veränderung der Beleuchtung von der Rückseite des Substrats her bewirkt wird, oder durch Reduzierung der Konzentration des Fluorids im Elektrolyten.

Vorzugsweise werden die Lochstrukturen mit einem Mittenabstand von 1 bis 2 um erzeugt. Die Lochstrukturen weisen vorzugsweise im Bereich der ersten Hauptfläche einen Durchmesser von 0,2 bis 1 µm auf. Sie werden dabei in einer Tiefe von vorzugsweise 1 bis 30 µm erzeugt. Die Hohlräume im unteren Bereich der Lochstrukturen werden mit einem Durchmesser von vorzugsweise 0,5 bis 1,8 µm erzeugt.

In dieser Ausführungsform läßt sich die thermische Leitung ins übrige Substrat noch weiter dadurch verringern, daß die Oberfläche der Hohlräume oxidiert wird.

Gemäß einer weiteren Ausführungsform wird die thermische Leitung zwischen dem strukturierten Bereich und dem übrigen Substrat dadurch herabgesetzt, daß unter den Lochstrukturen ein großflächiger Hohlraum erzeugt wird, durch den senkrecht zur ersten Hauptfläche verlaufende Stützen aus Silizium verlaufen. Dazu werden die Lochstrukturen in dem strukturierten Bereich mit einer inhomogenen Verteilung in der ersten Hauptfläche erzeugt. Die inhomogene Verteilung wird insbesondere durch eine in der ersten Hauptfläche hergestellte Oberflächentopologie vorgegeben. Beim elektrochemischen Ätzen werden dann bei Erreichen einer vorgegebenen Tiefe der Lochstrukturen, die im wesentlichen der Tiefe des strukturierten Bereichs entspricht, die Prozeßparameter so geändert, daß der Querschnitt der Locher wachst. Die Ätzung wird solange fortgesetzt, bis in Bereichen höherer Dichte der Lochstrukturen benachbarte Lochstrukturen unter Bildung des Hohlraums zusammenwachsen. In Bereichen geringerer Dichte der Lochstrukturen bleibt dabei zwischen benachbarten Lochstrukturen eine Stütze aus Silizium erhalten.

Vorzugsweise werden die Stützen aus Silizium so angeordnet, daß die Pyrodetektorelemente nicht oberhalb der Stützen angeordnet werden müssen. Um eine ausreichende mechanische Stabilität der Pyrodetektoranordnung zu erzielen, ist es vorteilhaft, die Stutzen aus Silizium in einem Abstand von 100 - 500 µm vorzusehen.

Zur Herstellung des Hohlraums liegt es im Rahmen der Erfindung, die Stromdichte im Elektrolyten zu erhöhen oder die Konzentration des Fluorids im Elektrolyten zu reduzieren. Zur Erhöhung der Stromdichte im Elektrolyten wird vorzugsweise die Beleuchtung durch die zweite Hauptfläche des Substrats verändert.

Im folgenden wird die Erfindung anhand der Figuren und der Ausführungsbeispiele näher erläutert.
- Fig. 1: zeigt eine Pyrodetektoranordnung bei der ein strukturierter Bereich oberhalb einer Vertiefung angeordnet ist.
- Fig. 2: zeigt eine Pyrodetektoranordnung, bei der Lochstrukturen in einem strukturierten Bereich im unteren Teil Hohlräume aufweisen.
- Fig. 3: zeigt eine Pyrodetektoranordnung mit einem strukturierten Bereich, der oberhalb eines großflächigen Hohlraums angeordnete Lochstrukturen umfaßt.

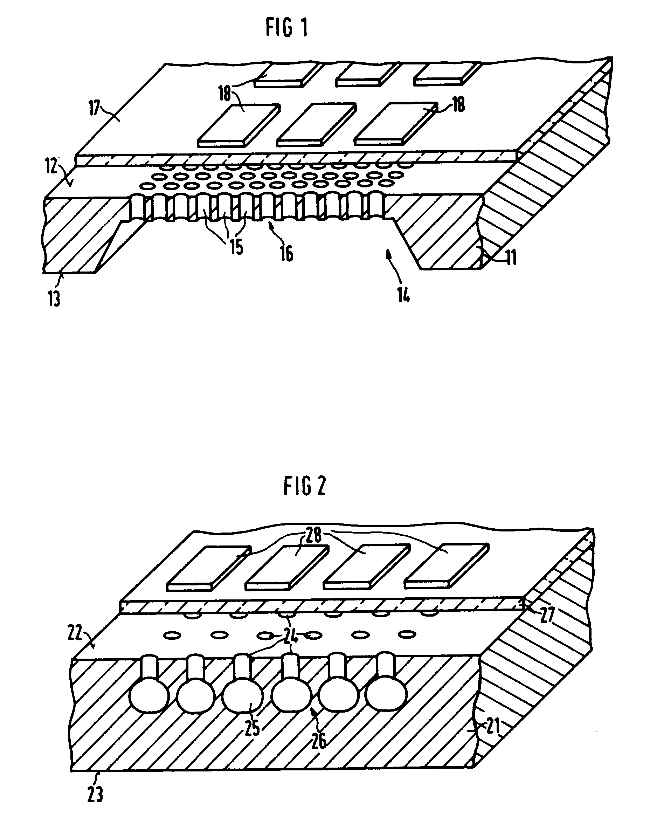

Ein Substrat 11 aus n-dotiertem, monokristallinem Silizium, das eine erste Hauptfläche 12 und eine der ersten gegenüberliegende zweite Hauptfläche 13 aufweist, wird von der zweiten Hauptfläche 13 her mit einer Vertiefung 14 versehen (Fig. 1). Das Substrat 11 weist einen elektrischen Widerstand von z. B. 5 Ω cm auf. Die Vertiefung 14 wird z. B. dadurch hergestellt, daß auf die zweite Hauptfläche 13 eine Fotolackmaske (nicht dargestellt) aufgebracht wird und daß eine alkalische Ätzung durchgeführt wird.

Anschließend werden von der ersten Hauptfläche 12 her Lochstrukturen 15 in den Bereich oberhalb der Vertiefung 14 hergestellt. Dazu wird das Substrat 11 mit der ersten Hauptfläche 12 mit einem fluoridhaltigen, sauren Elektrolyten in Kontakt gebracht. Der Elektrolyt weist eine Flußsäurekonzentration von z. B. 1 bis 50 %, vorzugsweise 3 %, auf. Dem Elektrolyten kann ein Oxidationsmittel, z. B. Wasserstoffsuperoxid, zugesetzt werden, um die Entwicklung von Wasserstoffbläschen auf der ersten Hauptfläche 12 zu vermeiden.

Das Substrat 11 wird als Anode verschaltet. An das Substrat 11 und den Elektolyten wird eine Spannung von z. B. 0 bis 20 Volt, vorzugsweise 3 Volt, angelegt. Das Substrat 11 wird von der zweiten Hauptfläche 13 her mit Licht beleuchtet, so daß eine Stromdichte von z. B. 10 mA/cm² eingstellt wird. Ausgehend von Unebenheiten in der ersten Hauptfläche 12 werden dabei Lochstrukturen 15 erzeugt, die senkrecht zur ersten Hauptfläche 12 verlaufen. Die elektrochemische Ätzung wird solange fortgesetzt, bis die Lochstrukturen 15 oberhalb der Vertiefung 14 das gesamte Substrat 11 durchsetzen. Auf diese Weise entsteht ein strukturierter Bereich 16, der die Lochstrukturen 15 umfaßt und der oberhalb der Vertiefung 14 angeordnet ist.

Auf die erste Hauptfläche 12 wird ganzflächig eine planare Schicht 17 aufgebracht. Die planare Schicht 17 besteht z. B. aus SiO₂. Sie wird z. B. durch Oxidation oder durch Sputtern aufgebracht. Die planare Schicht 17 verschließt die Lochstrukturen 15 von der ersten Hauptfläche 12 her. Oberhalb des strukturierten Bereichs 16 werden auf die planare Schicht 17 Pyrodetektorelemente 18, die jeweils eine untere Elektrode, eine pyroaktive Schicht und eine obere Elektrode umfassen, aufgebracht. Es werden z. B. 8 Pyrodetektorelemente 18 aufgebracht. Die untere Elektrode besteht jeweils z. B. aus Platin, die pyroaktive Schicht besteht z. B. aus Bleititanat oder geeignet dotiertem Bleititanat, die obere Elektrode besteht z. B. aus Nickel oder Goldschwarz.

Der strukturierte Bereich 16 weist wegen der Lochstrukturen 15 eine geringe thermische Masse und kleine Wärmeleitfähigkeit auf. Durch die Vertiefung 14 ist darüberhinaus die thermische Leitung zwischen dem strukturierten Bereich 16 und dem übrigen Teil des Substrats 11 herabgesetzt. Es ist daher wichtig, daß die Pyrodetektorelemente 18 alle oberhalb des strukturierten Bereichs 16 angeordnet werden.

Die Verteilung der Lochstrukturen 15 in der ersten Hauptfläche 12 kann durch eine Topologie, mit der die erste Hauptfläche 12 vor der elektrochemischen Ätzung versehen wird, vorgegeben werden. Derjenige Bereich der ersten Hauptfläche 12, in dem die Lochstrukturen 15 hergestellt werden, wird z. B. durch eine Fotolackmaske, die vor der elektrochemischen Ätzung aufgebracht wird, definiert. Diese Fotolackmaske wird nach der Fertigstellung der Lochstrukturen 15 entfernt.

Ausgangsmaterial ist ein Substrat 21 mit einer ersten Hauptfläche 22 und einer zweiten Hauptfläche 23, die der ersten Hauptfläche 22 gegenüberliegt. Das Substrat 21 besteht aus n-dotiertem, monokristallinem Silizium und weist z. B. eine 〈100〉-Orientierung auf.

Auf die erste Oberflache 22 wird eine Fotolackmaske aufgebracht (nicht dargestellt), die nur einen Teil der ersten Hauptfläche 22 unbedeckt läßt, in dem im folgenden Lochstrukturen 24 erzeugt werden.

In dem von der Fotolackmaske unbedeckten Teil der ersten Hauptfläche 22 weist die erste Hauptfläche 22 eine Oberflächentopologie auf, die z. B. aus regelmäßig angeordneten Vertiefungen besteht. Diese Oberflächentopologie legt die Verteilung der Lochstrukturen 24 fest.

Die erste Hauptfläche 22 wird mit einem Elektrolyten in Kontakt gebracht. Der Elektrolyt ist fluoridhaltig und sauer. Er enthält eine Flußsäurekonzentration von z. B. 1 bis 50 %, vorzugsweise 3 %. Dem Elektrolyten kann ein Oxidationsmittel, z. B. Wasserstoffsuperoxid, zugesetzt werden, um die Entwicklung von Wasserstoffbläschen auf der ersten Hauptfläche 22 zu unterdrücken. Das Substrat 21 wird als Anode verschaltet. Zwischen das Substrat 21 und den Elektrolyten wird eine Spannung von 0 bis 20 Volt, vorzugsweise 3 Volt, angelegt. Das Substrat 21 wird von der zweiten Hauptfläche 23 her mit Licht beleuchtet, so daß eine Stromdichte von z. B. 10 mA/cm² eingestellt wird. Ausgehend von den Vertiefungen werden bei der elektrochemischen Ätzung die Lochstrukturen 24 erzeugt, die senkrecht zur ersten Hauptfläche 22 verlaufen.

Die Lochstrukturen 24 werden in einer Tiefe von z. B. 1 bis 30 µm, vorzugsweise 15 µm , erzeugt. Eine Tiefe von 30 µm ist mit den obengenannten Prozeßparametern nach etwa 60 Minuten Ätzzeit erreicht.

Nach Erreichen dieser Tiefe wird die anodische Stromdichte auf z. B. 30 mA/cm² erhöht. Dabei wird die Spannung zwischen dem Elektrolyten und dem Substrat 21 auf 2 Volt reduziert. Die Stromdichte wird weiterhin durch Beleuchtung der zweiten Hauptfläche des Substrats 21 eingestellt.

Durch die geänderten Prozeßparameter bei der elektrochemischen Ätzung vergrößern sich die Querschnitte der Lochstrukturen 24. Es kommt zur Ausbildung von Hohlräumen 25, die jeweils im unteren Bereich der Lochstrukturen 24 angeordnet sind. Die elektrochemische Ätzung wird fortgesetzt, bis die Hohlräume 25 einen Durchmesser von z. B. 0,5 µm aufweisen. Dieses ist nach etwa 10 Minuten der Fall.

Im oberen Bereich weisen die Lochstrukturen einen Durchmesser von z. B. 0,2 µm auf. Der Mittenabstand benachbarter Lochstrukturen 24 beträgt z. B. etwas mehr als 1 µm.

Die Lochstrukturen 24 und die Hohlräume 25 bilden einen strukturierten Bereich 26 des Substrats 21. Die Hohlräume 25 bewirken dabei eine weitgehende thermische Isolation zum darunterliegenden Substrat 21.

Auf die erste Hauptfläche 22 wird eine planare Schicht 27 aufgebracht. Die planare Schicht 27 verschließt die Lochstrukturen 24. Die planare Schicht 27 besteht z. B. aus SiO₂ und ist durch Oxidation oder Sputtern hergestellt. Auf die planare Schicht 27 werden oberhalb des strukturierten Bereichs 26 Pyrodetektorelemente 28 aufgebracht. Die Pyrodetektorelemente 28 bestehen jeweils aus einer unteren Elektrode aus z. B. Platin, einer pyroaktiven Schicht aus z. B. Bleititanat oder modifiziertem Bleititanat und aus einer oberen Elektrode aus z. B. Nickel oder Goldschwarz. Die Pyrodetektorelemente 28 sind ausschließlich oberhalb des strukturierten Bereichs 26 angeordnet.

In dieser Ausführungsform läßt sich die thermische Leitung aus dem strukturierten Bereich 26 in den übrigen Teil des Substrats 21 weiter verringern durch Oxidation der Oberfläche der Hohlräume 25.

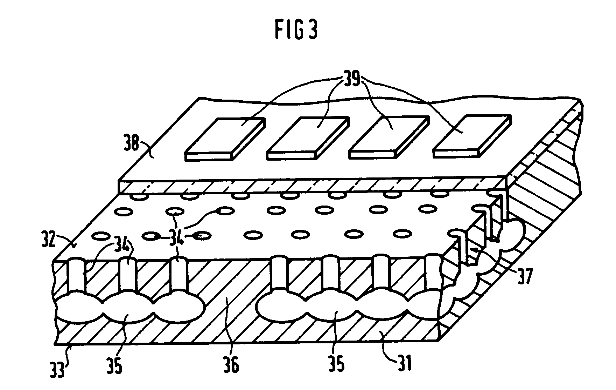

Als Ausgangsmaterial wird ein Substrat 31 aus monokristallinen n-dotiertem Silizium verwendet, das eine erste Hauptfläche 32 und eine zweite Hauptflache 33 aufweist, wobei die zweite Hauptfläche 33 der ersten Hauptfläche 32 gegenüberliegt (s. Fig. 3). Das Substrat 31 weist einen spezifischen Widerstand von z. B. 5 Ohm cm auf. Die erste Hauptfläche 32 wird mit einer Oberflächentopologie versehen, die aus ungleichmäßig dicht auf der ersten Hauptfläche 32 angeordneten Vertiefungen besteht.

Zur Erzeugung von Lochstrukturen 24 wird die erste Hauptfläche 32 mit einem fluoridhaltigen, sauren Elektrolyten in Kontakt gebracht. Der Elektrolyt weist eine Flußsäurekonzentration von z. B. 1 bis 50 %, vorzugsweise 3 % auf. Dem Elektrolyten kann ein Oxidationsmittel, z. B. Wasserstoffsuperoxid, zugesetzt werden, um die Entwicklung von Wasserstoffbläschen auf der ersten Hauptfläche 31 zu unterdrücken.

Das Substrat 31 wird als Anode verschaltet. Zwischen das Substrat 31 und den Elektrolyten wird eine Spannung von 0 bis 20 Volt, vorzugsweise 3 Volt angelegt. Das Substrat 31 wird von der zweiten Hauptfläche 33 her mit Licht beleuchtet, so daß eine Stromdichte von z. B. 10 mA/cm² eingestellt wird. Ausgehend von der Vertiefungen der Oberflächentopologie werden bei der elektrochemischen Ätzung Lochstrukturen 34 erzeugt, die senkrecht zur ersten Hauptfläche 32 verlaufen. Die Lochstrukturen weisen einen Durchmesser von z. B. 0,2 µm auf. Bei Erreichen einer Tiefe und 1 µm der Lochstrukturen 34 werden die Ätzparameter geändert. Die anodische Stromdichte wird auf z. B. 30 mA/cm² erhöht. Die Spannung zwischen Elektrolyt und Substrat 31 wird dabei auf 2 Volt reduziert. Die Stromdichte wird weiterhin durch Beleuchtung der zweiten Hauptfläche 33 des Substrats 31 eingestellt.

Durch die geänderten Parameter bei der elektrochemischen Ätzung vergrößern sich die Querschnitte der Lochstrukturen 34 im unteren Bereich bei der weiteren Ätzung. Es bilden sich am Boden der Lochstrukturen 34 höhlenförmige Erweiterungen aus. Die Ätzung wird fortgesetzt, bis in Bereichen, in denen die Lochstrukturen 34 eine hohe Dichte in der ersten Hauptfläche 32 aufweisen, das benachbarte höhlenförmige Erweiterung trennende Silizium weggeätzt ist und ein großflächiger Hohlraum 35 entsteht. In Bereichen, in denen die Lochstrukturen 34 eine geringere Dichte in der Flächenverteilung aufweisen, bleibt zwischen benachbarten Lochstrukturen 34 eine Stütze 36 bestehen, die von der ersten Hauptfläche 32 bis zu den die zweite Hauptfläche 33 aufweisenden Teil des Substrats 31 verlauft. Über diese Stützen 36 ist der durch die Lochstrukturen 34 gebildete strukturierte Bereich 37 des Substrats 31 mit dem übrigen Teil des Substrats 31 fest verbunden. Der Hohlraum 35 erstreckt sich unterhalb der Lochstrukturen 34 über den gesamten strukturierten Bereich 37 und wird nur durch die Stützen 36 unterbrochen. Um eine ausreichende mechanische Stabilität der Anordnung zu gewahrleisten, werden die Stützen 36 in einem Abstand von z. B. 100 - 500 µm angeordnet.

Auf die erste Hauptfläche 32 wird eine planare Schicht 38 aufgebracht, die die Lochstrukturen verschließt. Die planare Schicht 38 ist z. B. aus SiO₂ durch Oxidation oder Sputtern hergestellt. Auf die Oberfläche der planaren Schicht 38 werden Pyrodetektorelemente 39 aufgebracht, die jeweils aus einer unteren Elektrode aus Platin, einer pyroelektrischen Schicht aus z. B. Bleititanat oder modifiziertem Bleititanat und einer oberen Elektrode aus z. B. Nickel oder Goldschwarz aufgebaut werden. Es werden z. B. 8 Pyrodetektorelemente aufgebracht.

Die Pyrodetektorelemente 39 werden vorzugsweise so auf der planaren Schicht 38 angeordnet, daß die Stützen 36 im Substrat 31 zwischen benachbarten Pyrodetektorelementen 39 angeordnet sind. Auf diese Weise werden alle Pyrodetektorelemente 39 gleichermaßen thermisch isoliert aufgebracht.

## Patentansprüche

1. Verfahren zur Herstellung einer Pyrodetektoranordnung,
- bei dem mindestens in einem Teil einer ersten Hauptfläche (12, 22, 32) eines Substrats (11, 21, 31) aus n-dotiertem, monokristalinem Silizium durch elektrochemisches Ätzen Lochstrukturen (15, 24, 34) erzeugt werden, so daß ein strukturierter Bereich (16, 26, 37) in dem Substrat (11, 21, 31) entsteht, wobei das elektrochemische Ätzen in einem Elektrolyten erfolgt, in dem das Substrat (11, 21, 31) als Anode verschaltet ist, in dem die erste Hauptfläche (12, 22, 32) mit dem Elektrolyten in Kontakt steht und in dem eine den Ätzabtrag beeinflussende Stromdichte eingestellt wird,
- bei dem mindestens ein Pyrodetektorelement (18, 28, 39) oberhalb des strukturierten Teils der ersten Hauptfläche (12, 22, 32) realisiert wird.

2. Verfahren nach Anspruch 1,
bei dem das elektrochemische Ätzen in einem fluoridhaltigen, sauren Elektrolyten erfolgt.

3. Verfahren nach Anspruch 1 oder 2,
bei dem das Substrat (11, 21, 31) eine 〈100〉-Scheibe ist.

4. Verfahren nach einem der Ansprüche 1 bis 3,
bei dem vor der elektrochemischen Ätzung die erste Hauptfläche (12, 22, 32) mit einer Oberflächentopologie versehen wird, die die Anordnung der Lochstrukturen (15, 24, 34) bestimmt.

5. Verfahren nach einem der Ansprüche 1 bis 4,
bei dem die Stromdichte durch Beleuchtung einer der ersten Hauptfläche (12, 22, 32) gegenüberliegenden zweiten Hauptfläche (13, 23, 33) des Substrats (11, 21, 31) eingestellt wird.

6. Verfahren nach einem der Ansprüche 1 bis 5,
bei dem der Elektrolyt 1 bis 50 % Flußsäure (HF) enthält.

7. Verfahren nach Anspruch 6,
bei dem der Elektrolyt zusätzlich ein Oxidationsmittel enthält.

8. Verfahren nach einem der Ansprüche 1 bis 7,
bei dem zum Herabsetzen der thermischen Leitung zwischen dem strukturierten Bereich (16) und dem übrigen Teil des Substrats (11) vor dem elektrochemischen Ätzen in die zweite Hauptfläche (13) eine Vertiefung (14) geätzt wird, die unterhalb des strukturierten Bereichs (16) angeordnet ist und deren Ausdehnung parallel zur ersten Hauptfläche (12) mindestens so groß wie die des strukturierten Bereichs (16) ist.

9. Verfahren nach Anspruch 8,
bei dem die Vertiefung (14) in einer solchen Tiefe hergestellt wird, daß der strukturierte Bereich (16) eine Ausdehnung senkrecht zur ersten Hauptfläche (12) von 10 bis 100 µm aufweist.

10. Verfahren nach einem der Ansprüche 1 bis 7,
bei dem zum Herabsetzen der thermischen Leitung zwischen dem strukturierten Bereich (26) und dem übrigen Substrat (21) beim elektrochemischen Ätzen bei Erreichen einer vorgegebenen Tiefe der Lochstrukturen (24) die Prozeßparameter so geändert werden, daß der Querschnitt der Lochstruktur (24) wächst, so daß im unteren Bereich der Lochstrukturen (24) ein Netzwerk von Hohlräumen (25) entsteht.

11. Verfahren nach Anspruch 10,
bei dem die Stromdichte im Elektrolyten erhöht wird.

12. Verfahren nach Anspruch 10,
bei dem die Konzentration des Fluorids im Elektrolyten reduziert wird.

13. Verfahren nach einem der Ansprüche 10 bis 12,
bei dem die Oberfläche der Hohlräume (25) oxidiert wird.

14. Verfahren nach einem der Ansprüche 10 bis 13,
- bei dem die Lochstrukturen (24) mit einem Mittenabstand von 1 bis 2 µm erzeugt werden,
- bei dem die Lochstrukturen (24) im Bereich der ersten Hauptfläche (22) einen Durchmesser von 0,2 bis 1 µm aufweisen,
- bei dem die Lochstrukturen (24) in einer Tiefe von 1 bis 30 µm erzeugt werden,
- bei dem die Hohlräume (25) mit einem Durchmesser von 0,5 bis 1,8 µm erzeugt werden.

15. Verfahren nach einem der Ansprüche 1 bis 7,
bei dem die thermische Leitung zwischen dem strukturierten Bereich (37) und dem übrigen Substrat (31) dadurch herabgesetzt wird, daß die Lochstrukturen (34) in dem strukturierten Bereich (37) mit einer inhomogenen Verteilung in der ersten Hauptfläche (32) erzeugt werden und daß beim elektrochemischen Ätzen bei Erreichen einer vorgegebenen Tiefe der Lochstrukturen (34) die Prozeßparameter so geändert werden, daß der Querschnitt der Lochstrukturen (34) wächst, so daß in Bereichen höherer Dichte der Lochstrukturen (34) benachbarte Lochstrukturen (34) unter Bildung eines Hohlraumes (35) zusammenwachsen, während in Bereichen geringerer Dichte der Lochstrukturen (34) zwischen benachbarten Lochstrukturen (34) eine Stütze (36) aus Silizium erhalten bleibt.

16. Verfahren nach Anspruch 15,
bei dem die Stromdichte im Elektrolyten erhöht wird.

17. Verfahren nach Anspruch 15,
bei dem die Konzentration des Fluorids im Elektrolyten reduziert wird.

18. Verfahren nach einem der Ansprüche 15 bis 17,
bei dem die Pyrodetektorelemente (39) seitlich der Stützen (36) angeordnet werden.

19. Verfahren nach einem der Ansprüche 1 bis 18,
bei dem die Oberfläche des strukturierten Bereichs (37) mit einer planaren Schicht (38) versehen wird, auf die eine untere Elektrode, eine pyroaktive Schicht und eine obere Elektrode für das Pyrodetektorelement (18, 28, 39) aufgebracht wird.

20. Verfahren nach Anspruch 19,
bei dem die planare Schicht (17, 27, 38) aus SiO₂, die untere Elektrode aus Platin, die pyroaktive Schicht aus Bleititanat oder modifiziertem Bleititanat und die obere Elektrode aus Nickel oder Goldschwarz gebildet werden.
